# EUROPEAN PATENT SPECIFICATION

(11) **EP 4 582 936 B1**
(45) Date of publication and mention of the grant of the patent: **30.09.2026**
(21) Application number: 24869411.9
(22) Date of filing: 08.08.2024
(51) Int. Cl.: H05K 1/14, G06F 9/4401, G06F 1/184, G06F 1/185

(54) **BOARD AND SERVER**
BRETT UND SERVER
CARTE ET SERVEUR

(30) Priority: 25.09.2023 CN 202311244661
(43) Date of publication of application: 09.07.2025
(73) Proprietor: Suzhou Metabrain Intelligent Technology Co., Ltd., Suzhou, Jiangsu 215000 (CN)
(72) Inventor: LIU, Zhen, Suzhou, Jiangsu 215000 (CN); CI, Tanlong, Suzhou, Jiangsu 215000 (CN); JIA, Huijuan, Suzhou, Jiangsu 215000 (CN)
(74) Representative: von Bülow & Tamada
(86) International application number: PCT/CN2024/110676
(87) International publication number: WO 2025/066572

(56) References cited:
- CN-A- 111 258 948
- CN-A- 114 968 895
- CN-A- 115 098 422
- CN-A- 116 991 488
- US-A1- 2007 156 938
- US-A1- 2016 224 497
- US-A1- 2020 314 025

## Description

### CROSS-REFERENCE TO RELATED APPLICATION

The present disclosure claims the priority of Chinese patent application filed in CNIPA on September 25th, 2023 with the application number of 202311244661.4 and the application name of "A Chip Board and Server".

### FIELD

The present disclosure relates to the technical field of processor board interconnection, in particular to a board and a server.

### BACKGROUND

With the development of artificial intelligence, machine learning, high-performance computing and other complex computing scenarios, higher requirements are put forward for the data center architecture. Computing platforms requirements for different processing tasks are different, and computing power requirements for different application scenarios are different. In order to meet different requirements for data processing, data throughput and resource in different scenarios, the data center accelerates the transformation from a computing-centric architecture to a data-centric converged architecture. In the converged architecture, key devices such as CPU, GPU and SSD are decoupled into independent resource pools, and PCIe (a high-speed signal) bus has become the only carrier connecting many independent resource pools. Between CPU and GPU, between CPU and SSD, and between CPUs in different independent resource pools, huge data interaction is maintained through PCIe bus. In order to support the huge PCIe resource demand, the converged architecture design is introduced into PCIe Switch (also known as high-speed serial expansion bus switch) processors. Usually, multiple PCIe Switch processors are configured in one chassis. However, due to the complex construction of the converged architecture system, there are a large number of components, and the space of the chassis is limited, which makes it difficult and costly to build the converged architecture.

### SUMMARY

In view of the above problems, the present disclosure is defined by the subject-matter of claim 1.

Optionally, the first processor is provided with a corresponding third internal connector configuration area, and the third internal connector configuration area is arranged at a central area of the processor board close to one side of the first processor;
the second processor is provided with a corresponding fourth internal connector configuration area, and the fourth internal connector configuration area is arranged at one side of the central area close to the second processor;
the first processor is configured with a corresponding third internal connector, and the second processor is configured with a corresponding fourth internal connector;
the third internal connector is arranged in the third internal connector configuration area, and the fourth internal connector is arranged in the fourth internal connector configuration area; the first processor and the third internal connector are electrically connected through a third circuit, the second processor and the fourth internal connector are electrically connected through a fourth circuit, and the third circuit does not intersect with the fourth circuit.

Optionally, the third circuit does not intersect with the second circuit.

Optionally, the fourth circuit does not intersect with the second circuit.

Optionally, the first processor is configured with a corresponding first external connector, and the second processor is configured with a corresponding second external connector;
the first external connector are arranged in the first external connector configuration area, and the second external connector is arranged in the second external connector configuration area; the first processor and the first external connector are electrically connected through a fifth circuit, the second processor and the second external connector are electrically connected through a sixth circuit, and the fifth circuit does not intersect with the sixth circuit.

Optionally, the processor board is connected to other processor boards through the first internal connector, the second internal connector, the third internal connector and the fourth internal connector to form a processor board group;
the other processor boards have same structures as the processor board.

Optionally, the processor board group is formed by stacking the other processor boards and the processor board.

Optionally, the processor board group is configured in a two-unit chassis, and a quantity of layers of the processor board group is four.

The present disclosure further relates to server according to claim 9.

Optionally, the first processor is provided with a corresponding third internal connector configuration area, and the third internal connector configuration area is arranged at a central area of the processor board close to one side of the first processor;
the second processor is provided with a corresponding fourth internal connector configuration area, and the fourth internal connector configuration area is arranged at one side of the central area close to the second processor;
the first processor is configured with a corresponding third internal connector, and the second processor is configured with a corresponding fourth internal connector;
the third internal connector is arranged in the third internal connector configuration area, and the fourth internal connector is arranged in the fourth internal connector configuration area; the first processor and the third internal connector are electrically connected through a third circuit, the second processor and the fourth internal connector are electrically connected through a fourth circuit, and the third circuit does not intersect with the fourth circuit.

Optionally, the third circuit does not intersect with the second circuit.

Optionally, the fourth circuit does not intersect with the second circuit.

Optionally, the first processor is configured with a corresponding first external connector, and the second processor is configured with a corresponding second external connector;
the first external connector are arranged in the first external connector configuration area, and the second external connector is arranged in the second external connector configuration area; the first processor and the first external connector are electrically connected through a fifth circuit, the second processor and the second external connector are electrically connected through a sixth circuit, and the fifth circuit does not intersect with the sixth circuit.

Optionally, the processor board is connected to other processor boards through the first internal connector, the second internal connector, the third internal connector and the fourth internal connector to form a processor board group;
the other processor boards have same structures as the processor board.

Optionally, the processor board group is formed by stacking the other processor boards and the processor board.

Optionally, the processor board group is configured in a two-unit chassis, and a quantity of layers of the processor board group is four.

The embodiments of the present disclosure include the following advantage.
Multi-board interconnection based on the wiring design of the processor board in the embodiments of the present disclosure may effectively simplify the complexity of the cable topology structure in the processor board group, thereby improving the maintenance efficiency of multi-board interconnection and reducing the construction difficulty and maintenance cost.

### BRIEF DESCRIPTION OF THE DRAWINGS

FIG. 1 is a schematic structural diagram of an expansion bus processor board in a related art;
FIG. 2 is a schematic structural diagram A of a processor board provided in an embodiment of the present disclosure;
FIG. 3 is a schematic diagram of topological cable interconnection of a layout in a related art;
FIG. 4 is a schematic structural diagram A of a cable interconnection topology provided by an embodiment of the present disclosure;
FIG. 5 is a schematic structural diagram B of a processor board provided in an embodiment of the present disclosure;
FIG. 6 is a schematic structural diagram of a cable interconnection topology provided by the related art;
FIG. 7 is a schematic structural diagram A of a processor board group provided in an embodiment of the present disclosure;
FIG. 8 is a schematic structural diagram C of a cable interconnection topology provided by an embodiment of the present disclosure;
FIG. 9 is a schematic structural diagram B of a processor board group provided in an embodiment of the present disclosure;
FIG. 10 is a schematic structural diagram D of a cable interconnection topology provided by an embodiment of the present disclosure;
FIG. 11 is a schematic structural diagram C of a processor board group provided in an embodiment of the present disclosure.

Reference numerals: expansion bus processor board 10, first expansion bus processor 101, second expansion bus processor 102, first internal connector configuration area 101a, second internal connector configuration area 102a, first internal connector 1011, second internal connector 1021, first circuit 103, second circuit 104, third internal connector configuration area 101b, fourth internal connector configuration area 102b, third internal connector 1012, fourth internal connector 1022, third circuit 105, fourth circuit 106, first external connector configuration area 101c, second external connector configuration area 102c, first external connector 1013, second external connector 1023, fifth circuit 107, sixth circuit 108, other expansion bus processor boards 20, and expansion bus processor board group 30.

### DETAILED DESCRIPTION

In the following, the technical solution in the embodiments of the present disclosure will be clearly and completely described with reference to the appended drawings in the embodiments of the present disclosure.

In order to make the above objects, features and advantages of the present disclosure more obvious and easy to understand, the present disclosure will be further described in detail with the appended drawings and specific embodiments.

In order to make persons skilled in the art better understand the embodiments of the present disclosure, some technical terms involved in the embodiments of the present disclosure are explained below.

CPU: Central Processing Unit (CPU for short) is the operation and control core of computer system, and it is the final execution unit of information processing and program running. Since the emergence of CPU, it has made great progress in logical structure, operating efficiency and functional extension.

GPU: Graphics Processing Unit (GPU for short), also known as a display core, a visual processor, or a display processor, is a microprocessor specifically designed to perform image and graphics-related computations on personal computers, workstations, game consoles, and some mobile devices such as tablets and smartphones. The GPU reduces the reliance of the graphics board on the CPU and takes over some of the CPU's tasks. Especially in 3D graphics processing, the core technologies adopted by the GPU include hardware T&L (geometric transformation and illumination processing), cubic environment material mapping, vertex blending, texture compression, bump mapping, dual-texture four-pixel 256-bit rendering engine, etc. Among them, the hardware T&L technology may be regarded as a hallmark of the GPU.

SSD(Solid State Disk, also known as solid state hard disk) is a hard disk made of solid-state electronic storage processor array, and it is a computer storage device mainly using flash memory as permanent memory. It consists of a control unit and a storage unit. It is widely used in industrial control, video monitoring, network monitoring, network terminals, navigation equipment and many other fields.

PCIe (Peripheral Component Interconnect Express) is an expension bus standard for high-speed serial computers. Its original name is "3GIO", which aims to replace the old PCI, PCI-X and AGP bus standards. PCIe is a high-speed serial point-to-point dual-channel high-bandwidth transmission. The connected devices are allocated exclusive channel bandwidth, and do not share bus bandwidth. It mainly supports active power management, error reporting, end-to-end reliable transmission, hot plug and quality of service (QOS) and other functions.

PCIe Switch (also called high-speed serial expansion bus switch) provides expansion or aggregation capability, and allows more devices to connect to a PCle port. They act as packet routers and identify which path a given packet needs to take according to address or other routing information.

I/O Box(Input/Output Box), I/O Box refers to a device that provides an input/output (I/O) interface for connecting various network components. I/O Box may also be used as a network switch, allowing multiple devices to connect to a common network resource.

CXL, (Computer Express Link) is a high-speed interconnection protocol, which aims to provide higher data throughput and lower latency to meet the needs of modern computing and storage systems.

CXL Switch: A SW processor based on CXL protocol.

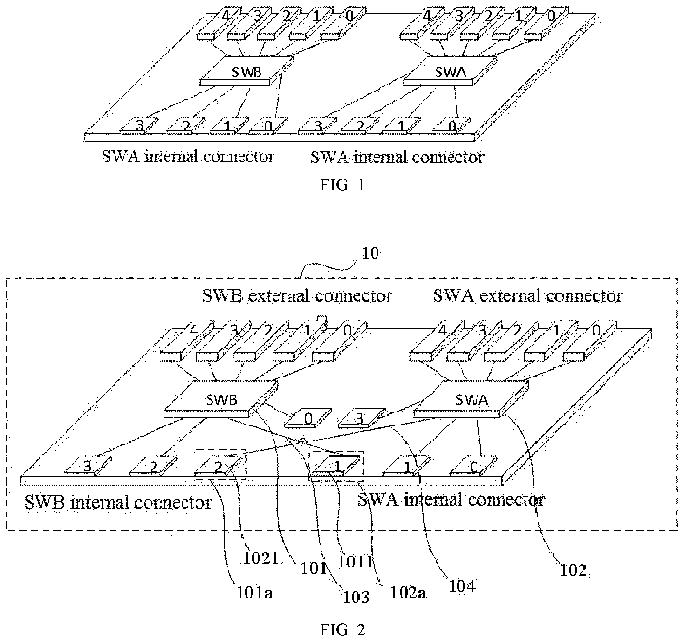

In practical application, in order to meet different data processing, data throughput and resource requirements in different scenarios, the data center is accelerating the transformation from a computing-centric architecture to a data-centric converged architecture. In the traditional server architecture design, PCIe Switch processor and CPU belong to a single master-slave relationship, which is used to expand PCIe resources of a single CPU. However, under the converged architecture, all PCIe resources in a cabinet are concentrated in one I/O Box. In order to share PCIe resources, several PCIe Switch processors are networked in the I/O Box. However, because the whole cabinet system has a certain body space, the body space of the I/O Box is limited (Illustratively, a height of 2 Units, where 1Unit=4.445cm). In order to realize the complex topology interconnection of PCIe Switch in a limited space and mount as many end devices as possible, one or two PCIe Switch processors are usually mounted under a CPU (refer to FIG. 1, FIG. 1 shows a structural schematic diagram of an expansion bus processor board in the related art), to expand PCIe resources, or to integrate multiple PCIe Switch processors on a board and realize interconnection among multiple PCIe Switch processors through intra-board wiring or cable interconnection. However, the above-mentioned methods cannot adapt to the application scenarios of resource pooling systems and cannot build a complex system topology. It is impossible to support the implementation of the converged architecture system, and the wiring is difficult, and the processing and maintenance costs are high. It is extremely difficult to debug, and it is also impossible to flexibly adjust the interconnection topology, and it is impossible to achieve downward compatibility for other topologies. The embodiments of the present disclosure propose a processor board, which combines the first internal connector configuration area and the second internal connector configuration area to optimize the layout of the processor board, and at the same time enables the processor board to downward compatibility for other interconnection topologies, further reducing the processing and maintenance costs.

In specific implementation, the processor board of the embodiments of the present disclosure may include, but is not limited to, an expansion bus processor board supporting PCIe protocol and a processor board supporting CXL protocol. Similarly, the first processor and the second processor may be a PCIe Switch or a CXL Switch.

In order to make those skilled in the art better understand the embodiments of the present disclosure, the embodiments of the present disclosure will be explained below by taking an expansion bus processor board as an example.

Referring to FIG. 2, a schematic structural diagram A of a processor board provided in an embodiment of the present disclosure is shown. The expansion bus processor board 10 is configured with a first expansion bus processor 101 and a second expansion bus processor 102.

The first expansion bus processor 101 is provided with a corresponding first internal connector configuration area 101a, and the first internal connector configuration area 101a is arranged at the lower edge position of the expansion bus processor board 10 close to one side of the first expansion bus processor 101;

The second expansion bus processor 102 is provided with a corresponding second internal connector configuration area 102a, and the second internal connector configuration area 102a is arranged at the lower edge position close to one side of the second expansion bus processor 102;

The first expansion bus processor 101 is configured with a corresponding first internal connector 1011, and the second expansion bus processor 102 is configured with a corresponding second internal connector 1021.

The first internal connector 1011 is arranged in the second internal connector configuration area 102a, and the second internal connector 1021 is arranged in the first internal connector configuration area 101a; The first expansion bus processor 101 and the first internal connector 1011 are electrically connected through a first circuit 103, and the second expansion bus processor 102 and the second internal connector 1021 are electrically connected through a second circuit 104, and the first circuit 103 and the second circuit 104 are arranged in an intersecting way.

In some embodiments of the present disclosure, the processor board may be a chip board, a first expansion bus processor 101 (that is, the first processor), and/or a second expansion bus processor 102 (that is, the second processor), which may be a chip.

In practical application, the expansion bus processor board 10 in the embodiments of the present disclosure may be a printed circuit board assembly (PCBA) board equipped with an expansion bus processor, and the PCBA refers to a printed circuit board that has undergone component mounting. The PCB is an important electronic component, a supporting body of electronic components, and is the provider of circuit connection of electronic components. The PCB is called "printed circuit board", because it is made by electronic printing technology. Before the appearance of printed circuit board, the interconnection between electronic components depended on the direct connection of wires to form a complete circuit. In addition, the first expansion bus processor 101 and/or the second expansion bus processor 102 may be PCIe Switch processors, also known as high-speed serial expansion bus switch processors, and at the same time, the first internal connector and/or the second internal connector may be an internal MCIO connector (Mini Cool Edge IO connector, also known as a cable assembly connector, may provide additional flexibility for signal use in high-performance channel systems).

In specific implementation, the expansion bus processor board 10 may be configured with a first expansion bus processor 101 and a second expansion bus processor 102, the first expansion bus processor 10 is provided with a corresponding first internal connector configuration area 101a, which is arranged at the lower edge position of the expansion bus processor board 10 close to one side of the first expansion bus processor 101; The second expansion bus processor 102 is provided with a corresponding second internal connector configuration area 102a, and the second internal connector configuration area 102a is arranged at the lower edge position close to one side of the second expansion bus processor 102; The first expansion bus processor 101 is configured with a corresponding first internal connector 1011, and the second expansion bus processor 102 is configured with a corresponding second internal connector 1021. The first internal connector 1011 is arranged in the second internal connector configuration area 102a, and the second internal connector 1021 is arranged in the first internal connector configuration area 101a; The first expansion bus processor 101 and the first internal connector 1011 are electrically connected through a first circuit 103, and the second expansion bus processor 102 and the second internal connector 1021 are electrically connected through a second circuit 104, and the first circuit 103 and the second circuit 104 are arranged in an intersecting way. Illustratively, the topological cable interconnection of the expansion bus processor board is shown in Table 1.

**Table 1:**

| | SW0 internal connector | SW2 internal connector | SW4 internal connector | SW6 internal connector |
|---|---|---|---|---|
| SW1 internal connector | 0-3 ←→ 1-0 | 2-2 ←→ 1-3 | 4-1 ←→ 1-1 | 6-0 ←→ 1-2 |
| SW3 internal connector | 0-0 ←→ 3-1 | 2-3 ←→ 3-0 | 4-2 ←→ 3-3 | 6-1 ←→ 3-2 |
| SW5 internal connector | 0-2 ←→ 5-2 | 2-0 ←→ 5-1 | 4-3 ←→ 5-0 | 6-2 ←→ 5-3 |
| SW7 internal connector | 0-1 ←→ 7-3 | 2-1 ←→ 7-2 | 4-0 ←→ 7-1 | 6-3 ←→ 7-0 |

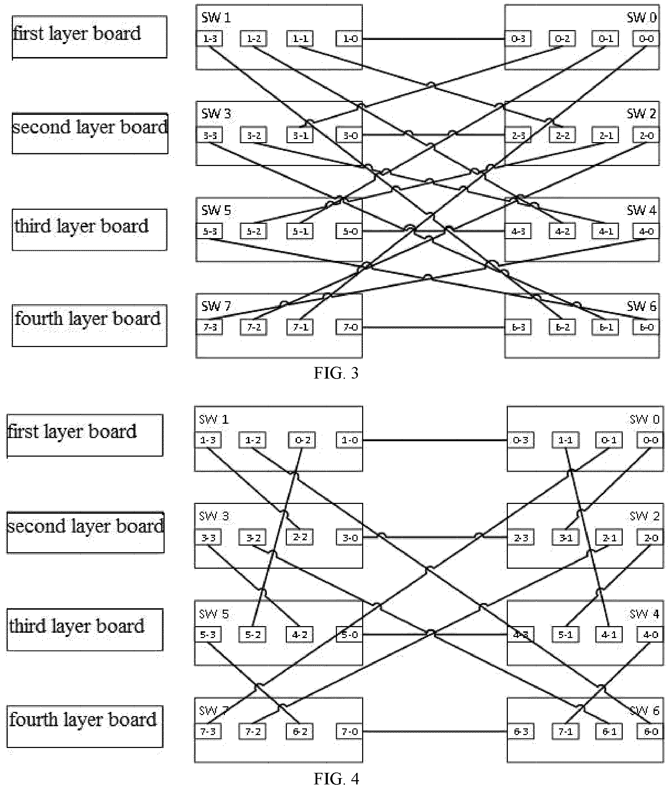

Let the first expansion bus processors be designated as "SW1", "SW3", "SW5" and "SW7", the second expansion bus processors as "SW0", "SW2", "SW4" and "SW6", the first internal connectors as "1-1", "3-1", "5-1", "7-1" corresponding to the first expansion bus processors "SW1", "SW3", "SW5" and "SW7" respectively, and the second internal connectors as "0-2", "2-2", "4-2", "6-2" corresponding to the second expansion bus processors "SW0", "SW2", "SW4" and "SW6" respectively. If an interconnection method of the related art in FIG. 1 is followed, a connection result is as shown in FIG. 3, which makes the multi-board cable interconnection topology extremely complex, resulting in high cost of construction and maintenance, and low maintenance efficiency. However, the interconnection relationship of the embodiment of the present disclosure is shown in FIG. 4. It can be seen that the embodiment of the present disclosure greatly simplifies the complexity of cables under the condition of the same cable interconnection topology.

In the embodiments of the present disclosure, the expansion bus processor board is configured with the first expansion bus processor and the second expansion bus processor; The first expansion bus processor is provided with the corresponding first internal connector configuration area, which is arranged at a lower edge position of the expansion bus processor board close to the first expansion bus processor side; The second expansion bus processor is provided with the corresponding second internal connector configuration area, which is arranged at a lower edge position close to the second expansion bus processor; The first expansion bus processor is configured with the corresponding first internal connector, and the second expansion bus processor is configured with the corresponding second internal connector; The first internal connector is arranged in the second internal connector configuration area, and the second internal connector is arranged in the first internal connector configuration area; The first expansion bus processor is electrically connected to the first internal connector through a first circuit, the second expansion bus processor is electrically connected to the second internal connector through a second circuit, and the first circuit and the second circuit are arranged in an intersecting way., so that the complexity of the board cable is reduced, and the board cost is further reduced.

On the basis of the above-mentioned embodiments, a modified embodiment of the above-mentioned embodiments is proposed. It should be noted here that in order to make the description brief, only the differences from the above-mentioned embodiments are described in the modified embodiment.

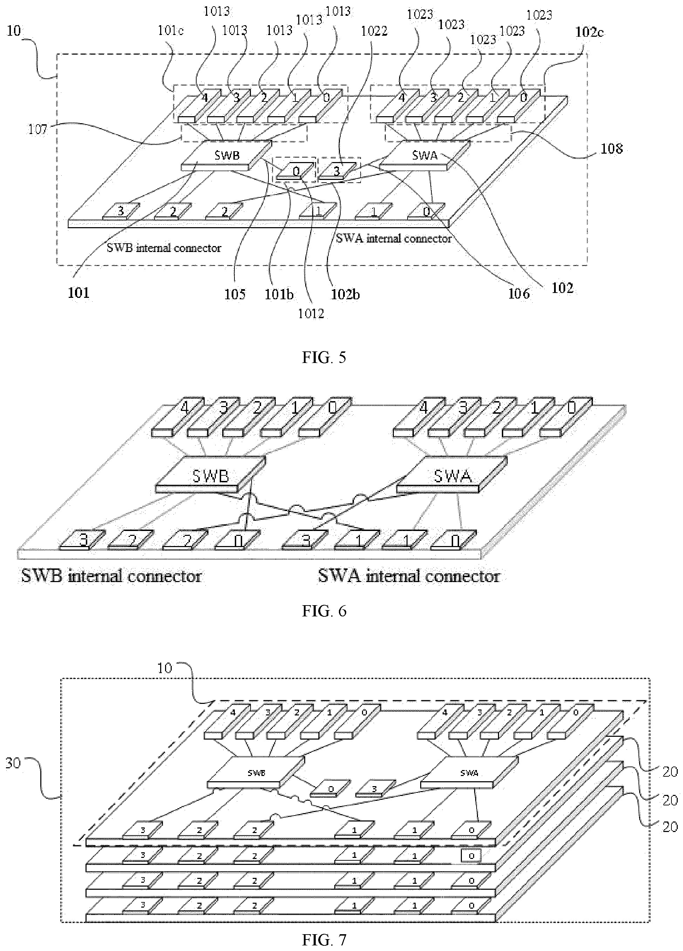

Referring to FIG. 5, a structural schematic diagram B of a processor board provided in an embodiment of the present disclosure is shown.

In an alternative embodiment of the present disclosure, the first expansion bus processor 101 is provided with a corresponding third internal connector configuration area 101b, which is arranged in a central area of the expansion bus processor board 10 close to one side of the first expansion bus processor 101;

The second expansion bus processor 102 is provided with a corresponding fourth internal connector configuration area 102b, and the fourth internal connector configuration area 102b is arranged in a central area close to one side of the second expansion bus processor 102;

The first expansion bus processor 101 is configured with a corresponding third internal connector 1012, and the second expansion bus processor 102 is configured with a corresponding fourth internal connector 1022.

The third internal connector 1012 is arranged in the third internal connector arrangement area 101b, and the fourth internal connector 1022 is arranged in the fourth internal connector arrangement area 102b; The first expansion bus processor 101 and the third internal connector 1012 are electrically connected through a third circuit 105, while the second expansion bus processor 102 and the fourth internal connector 1022 are electrically connected through a fourth circuit 106, and the third circuit 105 does not intersect with the fourth circuit 106.

In practical application, the third internal connector, and/or the fourth internal connector in the embodiments of the present disclosure may be an internal MCIO connector.

In the specific implementation, the first expansion bus processor in the embodiment of the present disclosure is provided with a corresponding third internal connector configuration area, and the third internal connector configuration area is arranged in the central area of the expansion bus processor board close to one side of the first expansion bus processor; The second expansion bus processor is provided with a corresponding fourth internal connector configuration area, and the fourth internal connector configuration area is arranged in the central area close to one side of the second expansion bus processor; The first expansion bus processor is configured with a corresponding third internal connector, and the second expansion bus processor is configured with a corresponding fourth internal connector; The third internal connector is arranged in the third internal connector configuration area and the fourth internal connector is arranged in the fourth internal connector configuration area; The first expansion bus processor is electrically connected to the third internal connector through a third circuit, the second expansion bus processor is electrically connected to the fourth internal connector through a fourth circuit, and the third circuit does not intersect with the fourth circuit. Illustratively, when the first expansion bus processor is "SWB", the second expansion bus processor is "SWA", the third internal connector is "0" and the fourth internal connector is "3", then "0" and "3" may be respectively placed in the third internal connector configuration area 101b and the fourth internal connector configuration area 102b in FIG. 5, and "SWB" and "0" are electrically connected through the third circuit 105, and "SWA" and "3" are electrically connected through the fourth circuit 106, wherein the third circuit 105 does not intersect with the fourth circuit 106. Referring to FIG. 6, FIG. 6 is a schematic structural diagram of a cable interconnection topology provided by the related art. FIG. 6 shows a result of circuit connection according to the related art under the same conditions. It can be seen that the embodiment of the present disclosure greatly simplifies the complexity of cables under the condition of the same topological cable interconnection, and at the same time, the length of the third circuit 105 and the fourth circuit 106 is shortened, thus improving the signal quality.

In the embodiments of the present disclosure, the first expansion bus processor is provided with a corresponding third internal connector configuration area, and the third internal connector configuration area is arranged in the central area of the expansion bus processor board close to one side of the first expansion bus processor; The second expansion bus processor is provided with a corresponding fourth internal connector configuration area, and the fourth internal connector configuration area is arranged in the central area close to one side of the second expansion bus processor; The first expansion bus processor is configured with a corresponding third internal connector, and the second expansion bus processor is configured with a corresponding fourth internal connector; The third internal connector is arranged in the third internal connector configuration area and the fourth internal connector is arranged in the fourth internal connector configuration area; The first expansion bus processor is electrically connected to the third internal connector through a third circuit, the second expansion bus processor is electrically connected to the fourth internal connector through a fourth circuit, and the third circuit does not intersect with the fourth circuit, thus reducing the manufacturing cost of the board and further improving the signal quality.

An embodiment of the present disclosure, the third circuit 105 does not intersect with the second circuit 104.

In the specific implementation, the multi-layer crossing of PCIe high-speed signals will increase the board layers, which will lead to an increase of PCBA cost. Therefore, by reducing the complexity of cables and reducing intersection points of the cables, the increase of PCBA cost caused by the multi-layer crossing of PCIe high-speed signals may be effectively avoided.

According to the embodiments of the present disclosure, the third circuit does not intersect with the second circuit, so that the processing cost of the board is reduced.

An embodiment of the present disclosure, the fourth circuit 106 does not intersect with the second circuit 104.

In the specific implementation, the multi-layer crossing of PCIe high-speed signals will increase the board layers, which will lead to an increase of PCBA cost. Therefore, by reducing the complexity of cables and reducing intersection points of the cables, the increase of PCBA cost caused by the multi-layer crossing of PCIe high-speed signals may be effectively avoided.

According to the embodiments of the present disclosure, the fourth circuit does not intersect with the second circuit, so that the processing cost of the board is further reduced.

In the present disclosure, the first expansion bus processor 101 is provided with a corresponding first external connector configuration area 101c, which is arranged at an upper edge position of the expansion bus processor board 10 close to one side of the first expansion bus processor 101.

In practical application, by arranging the external connector configuration area in a position close to the corresponding expansion bus processor, the intersection points and the length of cables may be effectively reduced, so that the signal quality may be guaranteed and the processing cost of the board may be reduced.

The first expansion bus processor is provided with the corresponding first external connector configuration area, and the first external connector configuration area is arranged at the upper edge position of the expansion bus processor board close to one side of the first expansion bus processor, thereby further ensuring the signal quality and reducing the processing cost of the board.

The second expansion bus processor 102 is provided with a corresponding second external connector configuration area 102c, and the second external connector configuration area 102c is arranged at the upper edge position of the expansion bus processor board 10 close to one side of the second expansion bus processor 102.

In practical application, by arranging the external connector configuration area in a position close to the corresponding expansion bus processor, the intersection points and the length of cables may be effectively reduced, so that the signal quality may be guaranteed and the processing cost of the board may be reduced.

**In** an embodiment of the present disclosure, the first expansion bus processor 101 is configured with a corresponding first external connector 1013, and the second expansion bus processor 102 is configured with a corresponding second external connector 1023;

The first external connector 1013 is arranged in the first external connector arrangement area 101c, and the second external connector 1023 is arranged in the second external connector arrangement area 102a. The first expansion bus processor 101 and the first external connector 1013 are electrically connected through a fifth circuit 107, while the second expansion bus processor 102 and the second external connector 1023 are electrically connected through a sixth circuit 108, and the fifth circuit 107 and the sixth circuit 108 do not intersect.

Illustratively, the first external connector and/or the second external connector may be an external CDFP(400 Form factor Pluggable) connector, which is a high-speed signal connector and may be used for signal transmission between different I/O boxes.

As such, the signal transmission quality is guaranteed, and the manufacturing cost of the board is further reduced.

Referring to FIG. 7, FIG. 7 shows a schematic structural diagram A of a processor board group provided in an embodiment of the present disclosure;

In an optional embodiment of the present disclosure, the expansion bus processor board 10 is connected to other expansion bus processor boards 20 through a first internal connector 1011, a second internal connector 1021, a third internal connector 1012 and a fourth internal connector 1022 to form an expansion bus processor board group 30.

Other expansion bus processor boards 20 have the same structure as the expansion bus processor board 10.

In practical application, when a topological structure is 2*n, that is, a number of the expansion bus processor boards is n, each of the expansion bus processor boards is provided with two expansion bus processors, if the expansion bus processors are formed into an expansion bus processor group, the space occupied by the chassis may be reduced and a large number of interconnection requirements may be met, and the complexity of PCBA may be simplified, the length of cables may be further reduced and the signal quality may be improved. Illustratively, connections may be made according to the topological cable interconnection relationship shown in Table 1.

In the embodiments of the present disclosure, the expansion bus processor board is connected to other expansion bus processor boards through the first internal connector, the second internal connector, the third internal connector and the fourth internal connector to form an expansion bus processor board group; Other expansion bus processor boards have the same structure as the expansion bus processor boards, thus reducing the space occupation of the chassis, further improving the signal quality and reducing the processing cost of the boards.

An embodiment of the present disclosure, the expansion bus processor board group 30 is formed by stacking the other expansion bus processor boards 20 and the expansion bus processor boards 10.

In the specific implementation, the other expansion bus processor boards 20 and the expansion bus processor boards 10 may be evenly and vertically distributed in the chassis and stacked to form an expansion bus processor board group.

In practical application, the stacked arrangement allows for the replacement of only the damaged board at the specific layer when a board fails, thereby enhancing the system's reliability and maintainability.

According to the embodiments of the present disclosure, the expansion bus processor board group is formed by stacking other expansion bus processor boards and expansion bus processor boards, so that the reliability of the system is improved, the subsequent operation and maintenance work is facilitated, and the operation and maintenance cost is reduced.

An embodiment of the present disclosure, the expansion bus processor board group 30 is configured in a two-unit chassis, and a quantity of layers of the expansion bus processor board group 30 is four.

In practical application, the two-unit chassis in the embodiments of the present disclosure may be a 2U chassis, and the height of the 2U chassis is 8.89cm. The 2U chassis is usually used for high-performance computer equipment such as servers, and has good heat dissipation and expansibility, and may be installed with multiple hard disks and slots. Illustratively, when the two-unit chassis is a 2U chassis, the number of layers of the expansion bus processor board group may be four. At the same time, 40 external connectors may be provided to meet the interconnection requirements of a large number of Host/Device, so that the expansion bus processor board group may better adapt to the size of the chassis and make higher use of the chassis space.

According to the embodiment of the present disclosure, the expansion bus processor board group is configured in the two-unit chassis, and the quantity of layers of the expansion bus processor board group is four, so that the space utilization rate of the system chassis is improved.

Optionally, the interconnection mode of the embodiment of the present disclosure may also be compatible with other topologies. Illustratively, the downwards compatibility of 2*3 standard topology and 2*2 Mesh (wireless mesh network) topology may take 2*3 standard topology as an example, that is, three expansion bus processor boards, each of which is provided with two expansion bus processors. Refer to Table 2 for the definition of cable interconnection relationship of standard topology.

**Table 2:**

| | SW0 internal connector | SW2 internal connector | SW4 internal connector |
|---|---|---|---|
| SW1 internal connector | 0-3 ←→ 1-0 | 2-2 ←→ 1-3 | 4-1 ←→ 1-1 |
| SW3 internal connector | 0-0 ←→ 3-1 | 2-3 ←→ 3-0 | 4-2 ←→ 3-3 |
| SW5 internal connector | 0-2 ←→ 5-2 | 2-0 ←→ 5-1 | 4-3 ←→ 5-0 |

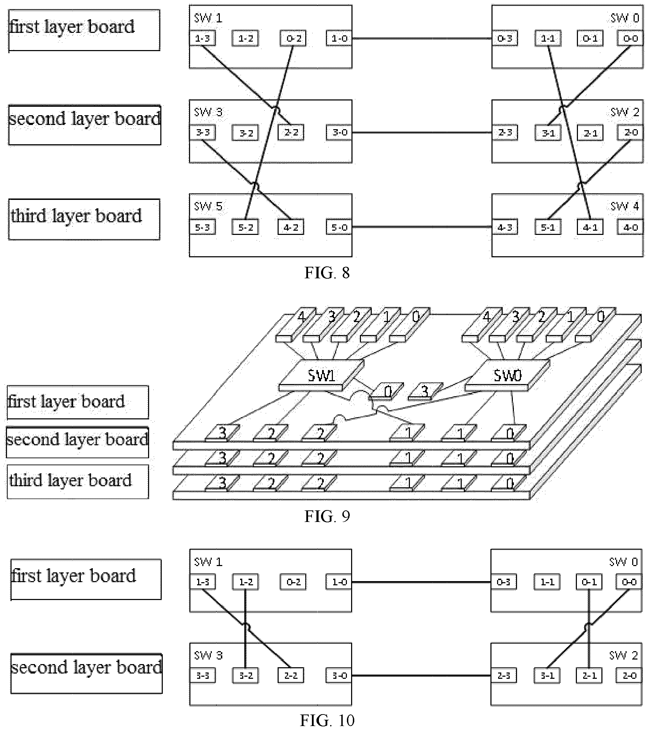

Referring to FIG. 8, FIG. 8 is a schematic diagram C of a cable interconnection topology provided by an embodiment of the present disclosure. FIG. 8 shows a cable topology corresponding to a 2*3 expension bus processor board group, FIG. 9 is a schematic diagram B of a processor board group provided by an embodiment of the present disclosure, and FIG. 9 shows a stacking structure of an expension bus processor board group with a 2*3 standard topology. It can be seen that for the cable interconnection mode of 2*3 standard topology, this 2*3 standard topology is a deformation of 2*4 topology, which is compatible in terms of structure and cable layout, and at the same time, there are 30 external connectors that may be used to meet the interconnection needs of a large number of Host/Device.

Take a 2*2 Mesh topology as an example. Refer to Table 3 for the definition of cable interconnection relationship in the 2*2 Mesh topology:

**Table 3:**

| | SW0 internal connector | SW1 internal connector | SW2 internal connector | SW3 internal connector |
|---|---|---|---|---|
| SW0 internal connector | / | | | |
| SW1 internal connector | 0-3←→1-0 | / | | |
| SW2 internal connector | 0-1←→2-1 | 1-3←→2-2 | / | |
| SW3 internal connector | 0-0←→3-1 | 1-2←→3-2 | 2-3←→3-0 | / |

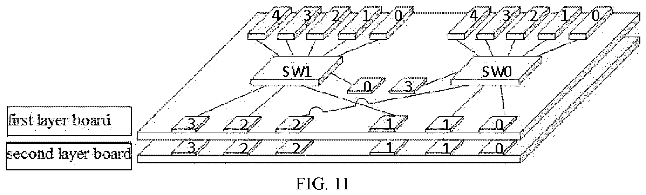

Referring to FIG. 10, FIG. 10 is a schematic diagram D of a cable interconnection topology provided by an embodiment of the present disclosure, and FIG. 10 shows a cable topology of a 2*2 Mesh expension bus processor board group. Referring to FIG. 11, FIG. 11 is a schematic diagram C of a processor board group provided by an embodiment of the present disclosure, and FIG. 11 shows a stacking structure of an expension bus processor board group corresponding to a 2*2 Mesh standard topology. It can be seen that the embodiment of the present disclosure may construct a cable interconnection mode for a 2*2 Mesh topology, which is a deformation of a 2*4 topology and has compatibility in terms of structure, cables and the like. At the same time, there are 20 external connectors that may be used to meet the interconnection needs of a large number of Host/Device.

The embodiments of the present disclosure also relate to a server according to claim 9.

Optionally, the first processor is provided with a corresponding third internal connector configuration area, and the third internal connector configuration area is arranged at a central area of the processor board close to one side of the first processor;
the second processor is provided with a corresponding fourth internal connector configuration area, and the fourth internal connector configuration area is arranged at one side of the central area close to the second processor;
the first processor is configured with a corresponding third internal connector, and the second processor is configured with a corresponding fourth internal connector;
the third internal connector is arranged in the third internal connector configuration area, and the fourth internal connector is arranged in the fourth internal connector configuration area; the first processor and the third internal connector are electrically connected through a third circuit, the second processor and the fourth internal connector are electrically connected through a fourth circuit, and the third circuit does not intersect with the fourth circuit.

Optionally, the third circuit does not intersect with the second circuit.

Optionally, the fourth circuit does not intersect with the second circuit.

The first processor is provided with a corresponding first external connector configuration area, and the first external connector configuration area is arranged at an upper edge position of the processor board close to one side of the first processor.

The second processor is provided with a corresponding second external connector configuration area, and the second external connector configuration area is arranged at an upper edge position of the processor board close to one side of the second processor.

Optionally, the first processor is configured with a corresponding first external connector, and the second processor is configured with a corresponding second external connector;
the first external connector are arranged in the first external connector configuration area, and the second external connector is arranged in the second external connector configuration area; the first processor and the first external connector are electrically connected through a fifth circuit, the second processor and the second external connector are electrically connected through a sixth circuit, and the fifth circuit does not intersect with the sixth circuit.

Optionally, the processor board is connected to other processor boards through the first internal connector, the second internal connector, the third internal connector and the fourth internal connector to form a processor board group;
the other processor boards have same structures as the processor board.

Optionally, the processor board group is formed by stacking the other processor boards and the processor board.

Optionally, the processor board group is configured in a two-unit chassis, and a quantity of layers of the processor board group is four.

As for the server embodiments, because they are basically similar to the embodiments of the expansion bus processor board, the description is relatively simple, and the relevant points may be found in the partial description of the embodiment of the expansion bus processor board.

Finally, it should be noted that in this paper, the terms "including", "containing" or any other variation thereof are intended to cover non-exclusive inclusion, so that a process, method, article or terminal equipment including a series of elements includes not only those elements, but also other elements not explicitly listed, or elements inherent to such process, method, article or terminal equipment. Without more restrictions, the element defined by the sentence "including one ...... "does not exclude that there are other identical elements in the process, method, article or terminal equipment including the element.

The above is only the specific implementation of the present disclosure, the protection scope of the present disclosure is based on the protection scope of the claims.

## Claims

1. A board, wherein the board is configured with a first processor and a second processor;
the first processor is provided with a corresponding first internal connector configuration area (101a), and the first internal connector configuration area (101a) is arranged at a lower edge position of the board and closer to one side of the first processor than to the second processor;
the second processor is provided with a corresponding second internal connector configuration area (102a), and the second internal connector configuration area (102a) is arranged at a lower edge position of the board and closer to one side of the second processor than to the first processor;
the first processor is configured with a corresponding first internal connector (1011), and the second processor is configured with a corresponding second internal connector (1021); and
the first internal connector (1011) is arranged in the second internal connector configuration area (102a);
the first processor and the first internal connector (1011) are electrically connected through a first circuit (103), and the second processor and the second internal connector (1021) are electrically connected through a second circuit (104);
wherein the first processor is provided with a corresponding first external connector configuration area (101c), and the first external connector configuration area (101c) is arranged at an upper edge position of the board close to one side of the first processor; and
wherein the second processor is provided with a corresponding second external connector configuration area (102c), and the second external connector configuration area (102c) is arranged at an upper edge position of the board close to one side of the second processor,
**characterized in that** the second internal connector (1021) is arranged in the first internal connector configuration area (101a).

2. The board according to claim 1, wherein the first processor is provided with a corresponding third internal connector configuration area (101b), and the third internal connector configuration area (101b) is arranged at a central area of the board close to one side of the first processor;
the second processor is provided with a corresponding fourth internal connector configuration area (102b), and the fourth internal connector configuration area (102b) is arranged at the central area close to one side of the second processor;
the first processor is configured with a corresponding third internal connector (1012), and the second processor is configured with a corresponding fourth internal connector (1022); and
the third internal connector (1012) is arranged in the third internal connector configuration area (101b), and the fourth internal connector (1022) is arranged in the fourth internal connector configuration area (102b); the first processor and the third internal connector (1012) are electrically connected through a third circuit (105), the second processor and the fourth internal connector (1022) are electrically connected through a fourth circuit (106), and the third circuit (105) does not intersect with the fourth circuit (106).

3. The board according to claim 2, wherein the third circuit (105) does not intersect with the second circuit (104).

4. The board according to claim 2, wherein the fourth circuit (106) does not intersect with the second circuit (104).

5. The board according to claim 4, wherein the first processor is configured with a corresponding first external connector (1013), and the second processor is configured with a corresponding second external connector (1023); and
the first external connector (1013) are arranged in the first external connector configuration area (101c), and the second external connector (1023) is arranged in the second external connector configuration area (102c); the first processor and the first external connector (1013) are electrically connected through a fifth circuit (107), the second processor and the second external connector (1023) are electrically connected through a sixth circuit (108), and the fifth circuit (107) does not intersect with the sixth circuit (108).

6. The board according to claim 1 or 5, wherein the board is connected to other boards through the first internal connector (1011), the second internal connector (1021), the third internal connector (1012) and the fourth internal connector (1022) to form a board group; and
the other boards have same structures as the board.

7. The board according to claim 6, wherein the board group is formed by stacking the other boards and the board.

8. The board according to claim 7, wherein the board group is configured in a two-unit chassis, and a quantity of layers of the board group is four.

9. A server, wherein the server is configured with a board according to claim 1.

10. The server according to claim 9, wherein the first processor is provided with a corresponding third internal connector configuration area (101b), and the third internal connector configuration area (101b) is arranged at a central area of the board close to one side of the first processor;
the second processor is provided with a corresponding fourth internal connector configuration area (102b), and the fourth internal connector configuration area (102b) is arranged at the central area close to one side of the second processor;
the first processor is configured with a corresponding third internal connector (1012), and the second processor is configured with a corresponding fourth internal connector (1022); and
the third internal connector (1012) is arranged in the third internal connector configuration area (101b), and the fourth internal connector (1022) is arranged in the fourth internal connector configuration area (102b); the first processor and the third internal connector (1012) are electrically connected through a third circuit (105), the second processor and the fourth internal connector (1022) are electrically connected through a fourth circuit (106), and the third circuit (105) does not intersect with the fourth circuit (106).

11. The server according to claim 10, wherein the third circuit (105) does not intersect with the second circuit (104).

12. The server according to claim 10, wherein the fourth circuit (106) does not intersect with the second circuit (104).

13. The server according to claim 9, wherein the first processor is provided with a corresponding first external connector configuration area (101c), and the first external connector configuration area (101c) is arranged at an upper edge position of the board close to one side of the first processor.

## Patentansprüche

1. Platine, wobei die Platine mit einem ersten Prozessor und einem zweiten Prozessor ausgestattet ist;
wobei dem ersten Prozessor ein entsprechender erster interner Verbinderkonfigurationsbereich (101a) zugeordnet ist und der erste interne Verbinderkonfigurationsbereich (101a) an einer unteren Randposition der Platine angeordnet und näher an einer Seite des ersten Prozessors als an dem zweiten Prozessor ist;
wobei dem zweiten Prozessor ein entsprechender zweiter interner Verbinderkonfigurationsbereich (102a) zugeordnet ist und der zweite interne Verbinderkonfigurationsbereich (102a) an einer unteren Randposition der Platine angeordnet und näher an einer Seite des zweiten Prozessors als an dem ersten Prozessor ist;
wobei der erste Prozessor mit einem entsprechenden ersten internen Verbinder (1011) ausgestattet ist und der zweite Prozessor mit einem entsprechenden zweiten internen Verbinder (1021) ausgestattet ist; und wobei der erste interne Verbinder (1011) in dem zweiten internen Verbinderkonfigurationsbereich (102a) angeordnet ist;
wobei der erste Prozessor und der erste interne Verbinder (1011) elektrisch über einen ersten Schaltkreis (103) verbunden sind und der zweite Prozessor und der zweite interne Verbinder (1021) elektrisch über einen zweiten Schaltkreis (104) verbunden sind;
wobei dem ersten Prozessor ein entsprechender erster externer Verbinderkonfigurationsbereich (101c) zugeordnet ist und der erste externe Verbinderkonfigurationsbereich (101c) an einer oberen Randposition der Platine nahe einer Seite des ersten Prozessors angeordnet ist; und
wobei dem zweiten Prozessor ein entsprechender zweiter externer Verbinderkonfigurationsbereich (102c) zugeordnet ist und der zweite externe Verbinderkonfigurationsbereich (102c) an einer oberen Randposition der Platine nahe einer Seite des zweiten Prozessors angeordnet ist,
**dadurch gekennzeichnet, dass** der zweite interne Verbinder (1021) in dem ersten internen Verbinderkonfigurationsbereich (101a) angeordnet ist.

2. Platine nach Anspruch 1, wobei dem ersten Prozessor ein entsprechender dritter interner Verbinderkonfigurationsbereich (101b) zugeordnet ist und der dritte interne Verbinderkonfigurationsbereich (101b) in einem zentralen Bereich der Platine nahe einer Seite des ersten Prozessors angeordnet ist; wobei dem zweiten Prozessor ein entsprechender vierter interner Verbinderkonfigurationsbereich (102b) zugeordnet ist und der vierte interne Verbinderkonfigurationsbereich (102b) in dem zentralen Bereich nahe einer Seite des zweiten Prozessors angeordnet ist;
wobei der erste Prozessor mit einem entsprechenden dritten internen Verbinder (1012) ausgestattet ist und der zweite Prozessor mit einem entsprechenden vierten internen Verbinder (1022) ausgestattet ist; und wobei der dritte interne Verbinder (1012) in dem dritten internen Verbinderkonfigurationsbereich (101b) angeordnet ist und der vierte interne Verbinder (1022) in dem vierten internen Verbinderkonfigurationsbereich (102b) angeordnet ist; wobei der erste Prozessor und der dritte interne Verbinder (1012) elektrisch über einen dritten Schaltkreis (105) verbunden sind, der zweite Prozessor und der vierte interne Verbinder (1022) elektrisch über einen vierten Schaltkreis (106) verbunden sind und der dritte Schaltkreis (105) den vierten Schaltkreis (106) nicht schneidet.

3. Platine nach Anspruch 2, wobei der dritte Schaltkreis (105) den zweiten Schaltkreis (104) nicht schneidet.

4. Platine nach Anspruch 2, wobei der vierte Schaltkreis (106) den zweiten Schaltkreis (104) nicht schneidet.

5. Platine nach Anspruch 4, wobei der erste Prozessor mit einem entsprechenden ersten externen Verbinder (1013) ausgestattet ist und der zweite Prozessor mit einem entsprechenden zweiten externen Verbinder (1023) ausgestattet ist; und
wobei der erste externe Verbinder (1013) in dem ersten externen Verbinderkonfigurationsbereich (101c) angeordnet ist und der zweite externe Verbinder (1023) in dem zweiten externen Verbinderkonfigurationsbereich (102c) angeordnet ist; wobei der erste Prozessor und der erste externe Verbinder (1013) elektrisch über einen fünften Schaltkreis (107) verbunden sind, der zweite Prozessor und der zweite externe Verbinder (1023) elektrisch über einen sechsten Schaltkreis (108) verbunden sind und der fünfte Schaltkreis (107) den sechsten Schaltkreis (108) nicht schneidet.

6. Platine nach Anspruch 1 oder 5, wobei die Platine über den ersten internen Verbinder (1011), den zweiten internen Verbinder (1021), den dritten internen Verbinder (1012) und den vierten internen Verbinder (1022) mit anderen Platinen verbunden ist, um eine Platinengruppe zu bilden; und wobei die anderen Platinen dieselbe Struktur wie die Platine aufweisen.

7. Platine nach Anspruch 6, wobei die Platinengruppe durch Stapeln der anderen Platinen und der Platine gebildet wird.

8. Platine nach Anspruch 7, wobei die Platinengruppe in einem Zwei-Einheiten-Gehäuse konfiguriert ist und eine Anzahl von Schichten der Platinengruppe vier beträgt.

9. Server, wobei der Server mit einer Platine nach Anspruch 1 ausgestattet ist.

10. Server nach Anspruch 9, wobei dem ersten Prozessor ein entsprechender dritter interner Verbinderkonfigurationsbereich (101b) zugeordnet ist und der dritte interne Verbinderkonfigurationsbereich (101b) in einem zentralen Bereich der Platine nahe einer Seite des ersten Prozessors angeordnet ist; wobei dem zweiten Prozessor ein entsprechender vierter interner Verbinderkonfigurationsbereich (102b) zugeordnet ist und der vierte interne Verbinderkonfigurationsbereich (102b) in dem zentralen Bereich nahe einer Seite des zweiten Prozessors angeordnet ist;
wobei der erste Prozessor mit einem entsprechenden dritten internen Verbinder (1012) ausgestattet ist und der zweite Prozessor mit einem entsprechenden vierten internen Verbinder (1022) ausgestattet ist; und wobei der dritte interne Verbinder (1012) in dem dritten internen Verbinderkonfigurationsbereich (101b) angeordnet ist und der vierte interne Verbinder (1022) in dem vierten internen Verbinderkonfigurationsbereich (102b) angeordnet ist; wobei der erste Prozessor und der dritte interne Verbinder (1012) elektrisch über einen dritten Schaltkreis (105) verbunden sind, der zweite Prozessor und der vierte interne Verbinder (1022) elektrisch über einen vierten Schaltkreis (106) verbunden sind und der dritte Schaltkreis (105) den vierten Schaltkreis (106) nicht schneidet.

11. Server nach Anspruch 10, wobei der dritte Schaltkreis (105) den zweiten Schaltkreis (104) nicht schneidet.

12. Server nach Anspruch 10, wobei der vierte Schaltkreis (106) den zweiten Schaltkreis (104) nicht schneidet.

13. Server nach Anspruch 9, wobei dem ersten Prozessor ein entsprechender erster externer Verbinderkonfigurationsbereich (101c) zugeordnet ist und der erste externe Verbinderkonfigurationsbereich (101c) an einer oberen Randposition der Platine nahe einer Seite des ersten Prozessors angeordnet ist.

## Revendications

1. Carte, dans laquelle la carte est configurée avec un premier processeur et un second processeur ;
le premier processeur est pourvu d'une première zone de configuration de connecteur interne correspondante (101a), et la première zone de configuration de connecteur interne (101a) est agencée à une position de bord inférieur de la carte et plus près d'un côté du premier processeur que du second processeur ;
le second processeur est pourvu d'une seconde zone de configuration de connecteur interne correspondante (102a), et la seconde zone de configuration de connecteur interne (102a) est agencée à une position de bord inférieur de la carte et plus près d'un côté du second processeur que du premier processeur ;
le premier processeur est configuré avec un premier connecteur interne correspondant (1011), et le second processeur est configuré avec un second connecteur interne correspondant (1021) ; et
le premier connecteur interne (1011) est agencé dans la seconde zone de configuration de connecteur interne (102a) ;
le premier processeur et le premier connecteur interne (1011) sont connectés électriquement par un premier circuit (103), et le second processeur et le second connecteur interne (1021) sont connectés électriquement par un second circuit (104) ;
dans laquelle le premier processeur est pourvu d'une première zone de configuration de connecteur externe correspondante (101c), et la première zone de configuration de connecteur externe (101c) est agencée à une position de bord supérieur de la carte proche d'un côté du premier processeur ; et
dans laquelle le second processeur est pourvu d'une seconde zone de configuration de connecteur externe correspondante (102c), et la seconde zone de configuration de connecteur externe (102c) est agencée à une position de bord supérieur de la carte proche d'un côté du second processeur, **caractérisée en ce que** le second connecteur interne (1021) est agencé dans la première zone de configuration de connecteur interne (101a).

2. Carte selon la revendication 1, dans laquelle le premier processeur est pourvu d'une troisième zone de configuration de connecteur interne correspondante (101b), et la troisième zone de configuration de connecteur interne (101b) est agencée dans une zone centrale de la carte proche d'un côté du premier processeur ;
le second processeur est pourvu d'une quatrième zone de configuration de connecteur interne correspondante (102b), et la quatrième zone de configuration de connecteur interne (102b) est agencée dans la zone centrale proche d'un côté du second processeur ;
le premier processeur est configuré avec un troisième connecteur interne correspondant (1012), et le second processeur est configuré avec un quatrième connecteur interne correspondant (1022) ; et
le troisième connecteur interne (1012) est agencé dans la troisième zone de configuration de connecteur interne (101b), et le quatrième connecteur interne (1022) est agencé dans la quatrième zone de configuration de connecteur interne (102b) ; le premier processeur et le troisième connecteur interne (1012) sont connectés électriquement par un troisième circuit (105), le second processeur et le quatrième connecteur interne (1022) sont connectés électriquement par un quatrième circuit (106), et le troisième circuit (105) ne croise pas le quatrième circuit (106).

3. Carte selon la revendication 2, dans laquelle le troisième circuit (105) ne croise pas le second circuit (104).

4. Carte selon la revendication 2, dans laquelle le quatrième circuit (106) ne croise pas le second circuit (104).

5. Carte selon la revendication 4, dans laquelle le premier processeur est configuré avec un premier connecteur externe correspondant (1013), et le second processeur est configuré avec un second connecteur externe correspondant (1023) ; et
le premier connecteur externe (1013) est agencé dans la première zone de configuration de connecteur externe (101c), et le second connecteur externe (1023) est agencé dans la seconde zone de configuration de connecteur externe (102c) ; le premier processeur et le premier connecteur externe (1013) sont connectés électriquement par un cinquième circuit (107), le second processeur et le second connecteur externe (1023) sont connectés électriquement par un sixième circuit (108), et le cinquième circuit (107) ne croise pas le sixième circuit (108).

6. Carte selon la revendication 1 ou 5, dans laquelle la carte est connectée à d'autres cartes par le premier connecteur interne (1011), le second connecteur interne (1021), le troisième connecteur interne (1012) et le quatrième connecteur interne (1022) pour former un groupe de cartes ; et les autres cartes ont les mêmes structures que la carte.

7. Carte selon la revendication 6, dans laquelle le groupe de cartes est formé par empilement des autres cartes et de la carte.

8. Carte selon la revendication 7, dans laquelle le groupe de cartes est configuré dans un châssis à deux unités, et un nombre de couches du groupe de cartes est de quatre.

9. Serveur, dans lequel le serveur est configuré avec une carte selon la revendication 1.

10. Serveur selon la revendication 9, dans lequel le premier processeur est pourvu d'une troisième zone de configuration de connecteur interne correspondante (101b), et la troisième zone de configuration de connecteur interne (101b) est agencée dans une zone centrale de la carte proche d'un côté du premier processeur ;
le second processeur est pourvu d'une quatrième zone de configuration de connecteur interne correspondante (102b), et la quatrième zone de configuration de connecteur interne (102b) est agencée dans la zone centrale proche d'un côté du second processeur ;
le premier processeur est configuré avec un troisième connecteur interne correspondant (1012), et le second processeur est configuré avec un quatrième connecteur interne correspondant (1022) ; et
le troisième connecteur interne (1012) est agencé dans la troisième zone de configuration de connecteur interne (101b), et le quatrième connecteur interne (1022) est agencé dans la quatrième zone de configuration de connecteur interne (102b) ; le premier processeur et le troisième connecteur interne (1012) sont connectés électriquement par un troisième circuit (105), le second processeur et le quatrième connecteur interne (1022) sont connectés électriquement par un quatrième circuit (106), et le troisième circuit (105) ne croise pas le quatrième circuit (106).

11. Serveur selon la revendication 10, dans lequel le troisième circuit (105) ne croise pas le second circuit (104).

12. Serveur selon la revendication 10, dans lequel le quatrième circuit (106) ne croise pas le second circuit (104).

13. Serveur selon la revendication 9, dans lequel le premier processeur est pourvu d'une première zone de configuration de connecteur externe correspondante (101c), et la première zone de configuration de connecteur externe (101c) est agencée à une position de bord supérieur de la carte proche d'un côté du premier processeur.
